(19) Europäisches Patentamt
European Patent Office
Office européen des brevets

(11) EP 1 064 701 B1

(12) EUROPÄISCHE PATENTSCHRIFT

(45) Veröffentlichungstag und Bekanntmachung des Hinweises auf die Patenterteilung:
**18.06.2003 Patentblatt 2003/25**

(21) Anmeldenummer: **99910343.5**

(22) Anmeldetag: **15.03.1999**

(51) Int Cl.⁷: **H01R 13/719**, H05K 9/00

(86) Internationale Anmeldenummer:
**PCT/EP99/01675**

(87) Internationale Veröffentlichungsnummer:
**WO 99/048173 (23.09.1999 Gazette 1999/38)**

(54) **GESCHIRMTES GEHÄUSE ZUR AUFNAHME VON ELEKTRONISCHEN SCHALTUNGEN ODER BAUELEMENTEN**

SHIELDED HOUSING FOR ELECTRONIC CIRCUITS OR COMPONENTS

BOITIER BLINDE POUR CIRCUITS OU COMPOSANTS ELECTRONIQUES

(84) Benannte Vertragsstaaten:
**DE FR GB**

(30) Priorität: **19.03.1998 DE 19811927**

(43) Veröffentlichungstag der Anmeldung:
**03.01.2001 Patentblatt 2001/01**

(73) Patentinhaber: **Continental Teves AG & Co. oHG 60488 Frankfurt am Main (DE)**

(72) Erfinder:
• **BURGDORF, Jochen**
  **D-63075 Offenbach (DE)**
• **LORECK, Heinz**
  **D-65510 Idstein (DE)**
• **MERZ, Carsten**
  **D-55218 Ingelheim (DE)**
• **SCHWETLICK, Uwe**
  **D-60599 Frankfurt am Main (DE)**

(56) Entgegenhaltungen:
GB-A- 2 184 293          US-A- 5 167 539
US-A- 5 248 266

• **PATENT ABSTRACTS OF JAPAN vol. 095, no. 001, 28. Februar 1995 & JP 06 290993 A (NIPPON SEIKI CO LTD), 18. Oktober 1994**

**Beschreibung**

Die Erfindung bezieht sich auf ein geschirmtes Gehäuse zur Aufnahme von elektronischen Schaltungen und/oder Bauelementen, die gegen elektromagnetische Störfelder empfindlich sind und/oder Störfelder ausstrahlen, mit einem elektrischen Anschluß in Form eines Anschlußkabels, Anschlußsteckers, einer Anschlußbuchse etc., mit einer Abschirmung in Form einer zumindest großenteils geschlossenen metallischen (aus leitfähigen Material bestehenden) Beschichtung der Gehäusewandung, und mit Filtereinrichtungen, die insbesondere in dem Eintritts- oder Durchtrittsbereich des Anschlusses in das Gehäuse gegen Störfelder wirksam sind.

Üblicherweise werden gegenüber eingestrahlten, hochfrequenten elektromagnetischen Feldern empfindliche elektronische Schaltungen in abgeschirmten Gehäusen untergebracht. Die Schirmung schützt die Schaltung vor dem direkten Einfall der hochfrequenten Felder. Die elektrischen Felder können allerdings auch indirekt über in das Gehäuse führende elektrische Leitungen zu der Schaltung gelangen und diese stören. Deshalb werden an der Eintrittstelle der Leitung in das Gehäuse bei hohen Frequenzen wirksame Filtereinrichtungen vorgesehen. Diese Filtereinrichtungen sind üblicherweise diskrete Durchführungs-filter bzw. Durchführungskondensatoren.

Die vorstehend beschriebene Anordnung kann auch bei Schaltungen eingesetzt werden, die hochfrequente elektromagnetische Felder aussenden, um die Umgebung vor dem Austritt von Feldern zu schützen.

Solche geschirmte Gehäuse werden üblicherweise aus Metall hergestellt, die Durchführungskondensatoren werden eingelötet, eingeschraubt oder eingepreßt.

Ein rauschunterdrückender Stecker wird in der US-A-5,167,539 beschrieben. Die Wandungen der Steckeraufnahme bestehen aus Metall.

Aus verschiedenen Gründen (Kosten, Gewicht, Elastizität) werden häufig Kunststoffgehäuse eingesetzt. Um die gewünschte Schirmwirkung zu erzielen, werden diese Gehäuse metallisiert. Die elektrische Verbindung zwischen Durchführungskondensator und Metallisierung ist mit einfachen Mitteln oft nicht lösbar.

Der Erfindung liegt daher die Aufgabe zugrunde, eine Gehäuse der eingangs genannten Art zu entwickeln, das sich durch einfachen Aufbau, geringen Herstellungsaufwand und durch eine hohe Filterwirkung, insbesondere im Eintrittsbereich der in das Gehäuse führenden Leitungen, auszeichnet.

Es hat sich gezeigt, daß diese Aufgabe durch das im Anspruch beschriebene Gehäuse gelöst wird, dessen Besonderheit darin besteht, daß zumindest in dem Eintritts- oder Durchführungsbereich Filtereinrichtungen mit Kondensatoren vorgesehen sind, die als integrale Bestandteile der Anschlußelemente und der Abschirmung ausgebildet sind.

Durch die Erfindung wird die Verwendung von diskreten, konstruktiv aufwendigen Durchfhrungskondensatoren entbehrlich. Statt dessen dienen die Strukturen im Bereich der Durchtrittsstellen, die aus den in das Gehäuse führenden, elektrisch leitfähigen Verbindungen (z.B. ins Gehäuse eingespritzte Steckerpins, Stanzgitter, sonstige Einlegeteile), aus den Isolierschichten (Dielektrika) und aus der Schirmung bestehen, als Durchführungskondensatoren.

Besonders vorteilhafte Ausführungsbeispiele des erfindungsgemäßen Gehäuses sind in den Unteransprüchen genannt.

Das Dielektrikum kann entweder aus dem Gehäusematerial bei der Gehäuseherstellung (z.B Kunststoff Spritzgußverfahren) oder in einem weiteren Arbeitsgang beispielsweise durch Lackieren, Laminieren, Drucken etc. auf die leitfähige Verbindung aufgebracht werden.

Die zweite Kondensatorplatte wird in einem Arbeitsgang mit der Schirmung z.B. durch Galvanisieren, Sputtern oder Lackieren aufgebracht.

Die Kapazität des erfindungsgemäß gebildeten Durchführungskondensators kann wie folgt berechnet werden:

Zweiplattenkondensator:

$$C = \in \cdot A / s;$$

$$\in = \in_0 \cdot \in_r, \; \in_0 = 8{,}85 \cdot 10^{-12} \; F/m$$

Zylinderkondensator:

$$C = 2\pi \cdot \in \cdot 1 / \ln(r_2/r_1)$$

Der Scheinwiderstand kann wie folgt berechnet werden:

$$X_c = 1 / (2\pi \cdot f \cdot C)$$

Je niedriger die zu filternde Frequenz, desto größer ist die erforderliche Kapazität des Durchführungskondensators. Eine große Kapazität des Durchführungskondensators wird mit großen Flächen A und geringem Abstand s der Kondensatorplatten erreicht.

Es werden folgende Vorteile erzielt und folgende Nachteile der bekannten Lösungen behoben:

- Wegfall der diskreten Durchführungskondensatoren und aller Produktionsschritte zu deren Einbau.
- Die Durchführungskondensatoren werden ohne zusätzlichen Arbeitsgang, z.B. in nur einem kostengünstigen Arbeitsgang hergestellt.

Im folgenden werden speziellen Ausführungs- beispiele der Erfindung und ihrer Wirkungsweisen beschrieben :

Zweiplattenkondensator:

$$C = \in \cdot A / s$$

$\in_r$ = 4,2, A = 2,5mm · 7,5mm, s = 10µm (lackiert)

$$C = 70pF$$

$$X_c = 1 / (2\pi \cdot 1,8GHz \cdot 70pF) = 1,3 \ \Omega$$

$$X_c = 1 / (2\pi \cdot 26MHz \cdot 70pF) = 87 \ \Omega$$

$\in_r$ = 4,2, A = 2,5mm · 7,5mm,

s = 0,3mm (Kunststoff gespritzt)

$$C = 2,3pF$$

$$X_c = 1 / (2\pi \cdot 1,8GHz \cdot 2,3pF) = 38 \ \Omega$$

Zylinderkondensator:

$$C = 2\pi \cdot \in \cdot 1 / \ln(r_2/r_1), \ 1 = 3mm,$$

$\in_r$ = 4,2, $r_1$ = 0,5mm, $r_2$ = 0,501mm

$$C = 350pF$$

$$X_c = 1 / (2\pi \cdot 1,8GHz \cdot 350pF) = 250m\Omega$$

$$X_c = 1 / (2\pi \cdot 1,8GHz \cdot 350pF) = 17,5\Omega$$

Folgende Varianten der Erfindung sind denkbar:

- Kombination der Erfindung mit bereits üblichen Techniken zur Darstellung von Leiterstrukturen auf Kunststoffgehäusen.
- Spezielle Ausformung der Kondensatorplatten zur Herstellung von Filterstrukturen (z.B. T- oder π-Filter) z.B. in Streifenleitungstechnik.

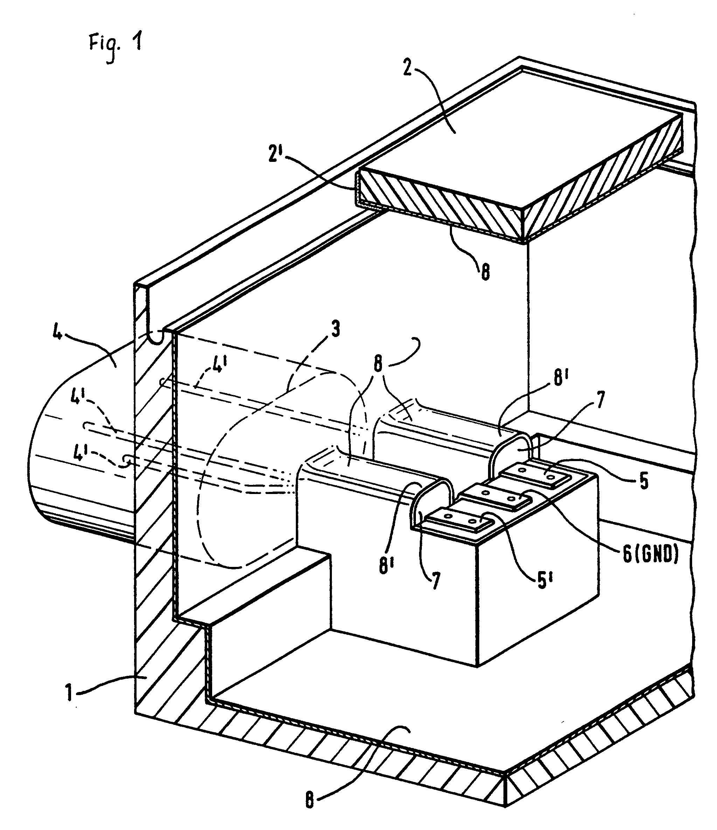

Die beigefügte Abbildung zeigt in perspektivischer, schematisch vereinfachter Art und als Teildarstellung ein Ausführungsbeispiel der Erfindung; das Gehäuse 1,2 ist aufgeschnitten, um die Ausbildung der auch als Kondensatoren dienenden Durchtrittsstelle zu veranschaulichen.

Das Gehäuse 1, 2 besteht hier aus einem quaderförmigen Hohlkörper 1 zur Aufnahme einer (nicht gezeigten) elektronischen Schaltung, eines gegen Störstrahlen empfindlichen Sensors oder dergleichen und ist mit einem nur teilweise wiedergegebenen Deckel 2 verschlossen.

Über eine Durchführung 3 und über eine (nicht gezeigte) mehradrige Anschlußleitung ist das Gehäuse, d.h. die Elektronik im Inneren des Gehäuses, mit den zugehörigen externen Schaltungen, einer Energieversorgung etc. verbunden.

Im abgebildeten Ausführungsbeispiel ist im Bereich der Dürchführung 3, die durch eine gestrichelt dargestellte Kante symbolisiert ist, eine Steckeraufnahmbuchse 4 angeordnet; genau genommen ist die Durchführung hier zu einer Aufnahmebuchse 4 erweitert, die den (nicht gezeigten) Stecker eines Anschluß- kabels aufnimmt; drei Elemente 4' zur Steckkontaktaufnahme sind im Inneren der Buchse 4 angedeutet.

Das Gehäuse 1, 2 besteht im vorliegenden Ausführungsbeispiel der Erfindung aus Kunststoff, der auf der Innenseite des Gehäuses mit einer elektrisch leitenden Schicht 8, die als Schirmung dient, versehen ist.

Erfindungswesentlich ist die Ausbildung der Durchführung 3 bzw. des Eintritts- oder Durchtrittsbereichs (3, 4) für den elektrischen Anschluß. Es handelt sich hier um einen dreiadrigen Anschluß. Die einzelnen, durch die Gehäusewandung hindurchgeführten Anschlußelemente enden in drei Stiften oder Plättohen 5, 5', 6. Der mittlere Anschlußstift 6 dient zum Anschluß an Masse GND, die beiden äußeren zur Signalzuführung (5) bzw. zur Stromversorgung (5').

Auf den Plättchen 5, 5' befindet eine als Dielektrikum dienende Schicht 7, die hier aus dem Gehäusematerial besteht. Dieses Dielektrikum 7 trägt eine weitere, aus elektrisch leitendem Material bestehende Schicht 8', die mit der Metallisierung oder Innenschicht 8 des Gehäuses 1, nämlich der Abschirmung, leitend verbunden ist. Erfindungsgemäß läßt sich diese Kondensatorschicht 8' als unmittelbarer, integraler Bestandteil der Abschirmung oder Innenschicht 8 herstellen. Es leuchtet ein, daß auf diese Weise die Kondensatoren oder Durchführungskondensatoren, die sich aus den Bestandteilen 5, 5', dem Dieletrikum 7 und den Metallschichten 8' zusammensetzen, auf sehr einfachem, ko- sten-günstigen Weg hergestellt werden können. Zum Auf- bringen des Dielektrikums 7 und der Kondensatorplatten 8' sind keine separaten Herstellungsschritte erforderlich, sondern dies geschieht gleichzeitig mit dem Gießen und Beschichten der Gehäusewandungen.

Nach dem Einsetzen der (nicht gezeigten) Elektronik in den Innenraum und Anschließen der Elektronik wird das erfindungsgemäße Gehäuse mit dem aufgesetzten und eingeklebten Deckel 2 verschlossen. Es wird vorzugsweise ein leitfähiger Klebstoff 2' verwendet, um eine völlig geschlossene Abschirmung zu verwirklichen.

## Patentansprüche

1. Geschirmtes Gehäuse zur Aufnahme von elektronischen Schaltungen und/oder Bauelementen, die gegen elektromagnetische Störfelder empfindlich sind und/oder Störfelder ausstrahlen, mit einem elektrischen Anschluß in Form eines Anschlußkabels, Anschlußsteckers, einer Anschlußbuchse etc., mit einer Abschirmung, wobei die Gehäusewandung aus Kunststoff hergestellt ist, mit Filtereinrichtungen, die insbesondere in dem Eintritts- oder Durchtrittsbereich des Anschlusses in das Gehäuse gegen Störfelder wirksam sind, und mit Filtereinrichtungen mit Kondensatoren (5, 5', 7, 8') zumindest in dem Eintritts- oder Durchführungsbereich (3), die als integrale Bestandteile der Anschlußelemente (3, 4) und der Abschirmung (8) ausgebildet sind, **dadurch gekennzeichnet, daß** die Anschlußelemente im Eintrittsoder Durchtrittsbereich (3, 4) in Form von in das Gehäuse (1, 2) eingesetzten oder eingespritzten Steckerpins, Stanzgitter, Anschlußfahnen oder dergl. (5, 5', 6) vorgesehen sind, auf die zur Bildung der Kondensatoren eine als Dielektrikum (7) dienende Schicht aus dem Gehäusematerial oder aus einem anderen Kunststoff, eine Lackschicht etc. aufgebracht ist, daß die Abschirmung in Form einer zumindest großenteils geschlossenen metallischen oder aus leitfähigem Material bestehenden Beschichtung der Gehäusewandung vorgesehen ist, und daß auf das Dielektrikum eine leitfähige, mit der Abschirmung (8) verbundene Schicht aufgebracht ist.

2. Geschirmtes Gehäuse nach Anspruch 1, **dadurch gekennzeichnet, daß** die auf das Dielektrikum (7) aufgebrachte Schicht in einem Arbeitsgang mit dem Aufbringen der Abschirmung (8, 8') auf die Gehäusewandung (1, 2) herstellbar ist.

## Claims

1. A shielded housing for accommodating electronic circuits and/or components which are sensitive to electromagnetic interference fields and/or radiate interference fields, the said shielded housing being fitted with an electrical connection in the form of a connecting cable, connecting plug, connecting socket, etc. and including a shield, with the housing wall being made of plastics, and including filter devices which are active against interference fields in particular in the area where the connection enters or penetrates the housing, and including filter devices with capacitors (5, 5', 7, 8') which are embodied as integral components of the connecting elements (3, 4) and of the shielding (8) at least in the area of entry or lead-in (3), **characterized in that**, in the area of entry or penetration (3, 4), the connecting elements are provided in the form of plug pins, punched grids, lugs or the like (5, 5', 6), inserted or injection-moulded into the housing (1, 2), to which elements there is applied a layer of the material of the housing or of another plastic material, a lacquer layer etc., which layer serves as dielectric (7), to form the capacitors, **in that** the shield is provided in the form of a coating on the housing wall which is closed at least to a large extent and consists of metal or any conductive material, and **in that** a conductive layer connected with the shield (8) is applied to said dielectric.

2. A shielded housing as claimed in claim 1, **characterized in that** the layer applied to the dielectric (7) can be manufactured in one operation with applying the shielding (8, 8') to the walls of the housing (1, 2).

## Revendications

1. Boîtier blindé servant à loger des composants et/ou circuits électroniques qui sont sensibles à des champs électromagnétiques parasites et/ou émettent des champs parasites, comprenant une connexion électrique se présentant sous forme d'un câble de connexion, d'une prise de connexion, d'une douille de connexion, etc., un blindage, la paroi de boîtier étant réalisée en matière plastique, des dispositifs de filtre, qui sont actifs vis-à-vis de champs parasites, notamment dans la zone d'entrée ou de traversée de la connexion dans le boîtier, et des dispositifs de filtre à condensateurs (5, 5', 7, 8'), situés au moins dans la zone d'entrée ou de traversée (3), qui sont réalisés sous forme de parties constitutives intégrées des éléments de connexion (3, 4) et du blindage (8), **caractérisé en ce que** les éléments de connexion sont prévus dans la zone d'entrée ou de traversée (3, 4) sous forme de broches de prise, grilles découpées, pattes de connexion ou analogues (5, 5', 6), posées ou mises en place à la coulée par injection dans le boîtier (1, 2), sur lesquelles est déposée, pour former les condensateurs, une couche provenant de la matière du boîtier ou d'une autre matière plastique, une couche de vernis, etc., servant de diélectrique (7), **en ce que** le blindage est prévu sous forme d'un revêtement de la paroi de boîtier, métallique ou constitué d'une matière conductrice, qui est fermée au moins pour la plus grande partie, et **en ce qu'**une couche conductrice reliée au blindage (8) est déposée sur le diélectrique.

2. Boîtier blindé suivant la revendication 1, **caractérisé en ce que** la couche déposée sur le diélectrique (7) peut être réalisée en une opération avec le dépôt du blindage (8, 8') sur la paroi de boîtier (1, 2).

Fig. 1